(19) Europäisches Patentamt
European Patent Office
Office européen des brevets

(11) Numéro de publication: **0 001 728**
**B1**

(12) **FASCICULE DE BREVET EUROPEEN**

(45) Date de publication du fascicule du brevet: **22.12.82**

(51) Int. Cl.³: **H 01 L 31/10, H 01 L 33/00.**

(21) Numéro de dépôt: **78400120.8**

(22) Date de dépôt: **29.09.78**

(54) **Diode émettrice et réceptrice de lumière notamment pour télécommunications optiques.**

(30) Priorité: **18.10.77 FR 7731274**

(43) Date de publication de la demande:
**02.05.79 Bulletin 79/9**

(45) Mention de la délivrance du brevet:
**22.12.82 Bulletin 82/51**

(84) Etats contractants désignés:
**BE DE GB NL**

(56) Documents cités:
**FR - A - 2 319 980**

(73) Titulaire: **THOMSON-CSF**
**173, Boulevard Haussmann**
**F-75379 Paris Cedex 08 (FR)**

(72) Inventeur: **de Cremoux, Baudouin**
**"THOMSON-CSF" - SCPI 173, bld. Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

**EP 0 001 728 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Diode émettrice et réceptrice de lumière notamment pour télécommunications optiques

L'invention a pour objet une diode émettrice et réceptrice de lumière pour télécommunication optique.

Le problème de la réalisation de telles diodes est particulièrement ardu. En effet, les qualités requises pour le fonctionnement en diode électroluminescente d'une part et en diode photodétectrice d'autre part, le tout fonctionnant dans la même bande de fréquences, sont difficilement conciliables. Diverses solutions ont été proposées.

La publication FR—A—2 319 980 fournit notamment dans sa figure 3 décrite pages 9 et 10, un dispositif réalisé sur un substrat 21 d'un premier matériau semiconducteur de type de conductivité n, comportant:

une première couche 22 d'un deuxième matériau semiconducteur de type n, déposé sur le substrat et présentant une première bande interdite de largeur prédéterminée;

une deuxième couche 23 dudit deuxième matériau de type p (présentant par conséquent la même bande interdite);

une troisième couche 28 d'un troisième matériau de type p présentant une deuxième bande interdite plus large que la première couche présentant en outre la particularité suivante: dans sa partie centrale on a procédé à une diffusion d'une impureté dopante de type p.

Ce dispositif a l'avantage de limiter la région active de la diode à l'émission, à l'aire strictement utile, par exemple à l'aire très petite correspondant à la section d'une fibre optique.

Il a toutefois l'inconvénient de présenter une région centrale diffusée mal délimitée sur sa périphérie, et une région périphérique qui est aussi mal délimitée sur sa périphérie ce qui entraîne deux inconvénients pratiques:

une trop grande capacité électrique, par suite de la grande surface de la région périphérique, ce qui est nuisible en très haute fréquence;

un plus grand courant d'obscurité.

L'invention tend à remédier à ces inconvénients en délimitant plus nettement les dimensions externes de la région centrale de la région périphérique d'une part, et d'autre part en ajoutant une quatrième couche qui favorise la concentration de courant générateur de photons.

Deux moyens sont utilisables pour délimiter plus nettement les dimensions externes de la région centrale et de la région périphérique; à savoir:

soit l'augmentation de résistivité de la région périphérique et l'exécution d'une gravure mésa de celle-ci;

soit la réalisation de deux dopages de types opposés et l'éxécution d'une gravure mésa de la région périphérique.

La diode selon l'invention est du type comportant:

un substrat semiconducteur d'un premier type de conductivité;

une première couche semiconductrice du même type de conductivité mais moins fortement dopée que le substrat;

une deuxième couche semiconductrice constituant la couche active, dont le matériau présente une bande interdite moins large que celle de la première couche, dopée p;

une troisième couche semiconductrice d'un second type de conductivité opposé audit premier type, dont le matériau présente une bande interdite plus large que celle de la deuxième couche.

Selon le moyen utilisé pour former la région centrale et la région périphérique, elle est caractérisée en ce qu'elle comporte en outre une quatrième couche semiconductrice présentant une région centrale du même type de conductivité que la troisième couche et une région périphérique de grande résistance ohmique, délimitée par une gravure mésa; ou au contraire la quatrième couche semiconductrice est constituée par un matériau d'un type de conductivité opposé à celui de la troisième couche dans lequel on a effectué une diffusion d'impuretés du même type de conductivité que la troisième couche dans la région centrale, la région périphérique demeurée du même type de conductivité étant délimitée par une gravure mésa.

L'invention sera mieux comprise au moyen de la description ci-après en se référant aux dessins annexés parmi lesquels:

la figure 1 et la figure 2 représentent en coupe et vu de dessus, respectivement un premier exemple de réalisation de l'invention;

la figure 3 représente en coupe la diode de la figure 1 en régime de photoémission;

la figure 4 représente en coupe la même diode en régime de photoréception;

les figures 5 et 6 représentent en coupe un second et un troisième exemples de réalisation, respectivement.

Sur la figure 1, sur un substrat 10 en Arséniure de Gallium (GaAs) de type p de conductivité, dopé au zinc avec une densité de concentration de $10^{18}$ At/cm$^3$, on a formé par les procédés bien connus d'épitaxie en phase liquide, quatre couches 1, 2, 3, 4, les deux première de type p, mais moins dopées que le substrat ($10^{16}$ à $10^{17}$ At/cm$^3$), les deux secondes 3 et 4 de type n et de dopage de l'ordre de $10^{17}$ At/cm$^3$. Les couches épitaxiales ont pour formules chimiques des combinaisons de type $Ga_{1-x}$, $Al_x$,

As, la valeur de x variant d'une couche à l'autre, ce qui a pour effet que toutes ces couches ont des bandes interdites de largeurs différentes. Une seule de ces couches, ici la couche 2, a la largeur de bande interdite appropriée pour absorber en polarisation inverse et émettre en polarisation directe des rayons lumineux d'une bande de longueurs d'onde prédéterminée, les autres couches étant transparentes à ce rayonnement. La couche 4 a une région 40 dans sa périphérie qui a été soumise à un bombardement protonique et est rendue isolante de ce fait. Néanmoins, comme la couche 3, elle est transparente aux radiations lumineuses de la bande prédéterminée dont il est question plus haut. Un contact métallique 41 est pris sur la couche 4.

L'ensemble est représenté vu du dessus sur la figure 2. La partie centrale de la zone 4 a un diamètre de l'ordre de 50 $\mu$m. Le contact ohmique 41 peut être pris par évaporation sous vide et photolithogravure.

L'ensemble a subi une attaque "mésa" et le contact qui a la forme représentée peut être relié à la source d'alimentation. Le fonctionnement de l'ensemble se comprendra à l'aide des figures 3 et 4.

(A) Fonctionnement en émission (diode électroluminescente): La diode est polarisée pour délivrer un courant de 50 à 100 mA en direct. La couche 2 ou couche active est le siège d'un courant électrique intense (densité par unité de volume $10^7$ Amp/cm$^3$). Ceci compense la faiblesse de son dopage qui est de l'ordre de $10^{17}$ At/cm$^3$. Ce courant est concentré dans un faible volume grâce à la zone 40 qui est fortement résistive. Il en résulte que l'émission de photons se produira uniquement dans la zone centrale 4 qui a par exemple un diamètre de 50 $\mu$m. Ce diamètre est suffisamment faible pour que le rayonnement soit recueilli de façon convenable par la fibre optique 50 disposée au dessus de la surface 40.

Or ces qualités sont contradictoires avec celles qui sont exigées d'une diode photoréceptrice dont le fonctionnement va être décrit maintenant.

(B) Fonctionnement en réception. La diode est alors polarisée en inverse sous 10 volts: conformément á l'invention, l'ensemble zone 4 — zone 40 est soumise au rayonnement. Cet ensemble laisse passer, en raison de sa transparence, les photons. La polarisation de l'ordre de 10v pour une couche ayant une concentration d'impuretés de l'ordre de $10^{17}$ At/cm$^3$ et son épaisseur sont telles qu'elle soit au moins partiellement en charge d'espace, ou au moins que la longueur de diffusion des porteurs minoritaires soit grande. Un courant se produit par l'échange de trous et d'électrons. Ce courant étant faible, la présence des zones 40 ne sera pas génante, et c'est toute la zone active qui fonctionnera en détection car toute la surface exposée aux rayons lumineux contribuera à l'accès des photons à la zone active. La diode selon l'invention se comportera donc comme s'il y avait deux diodes, l'une, émissive à faible diamètre fonctionnant sous un régime de courant fort, l'autre ayant une grande surface réceptrice et une couche active d'épaisseur et de dopage appropriés pour que l'impact des photons crée des paires électrons-trous avec un rendement suffisant pour engendrer un courant électrique.

Le tableau suivant donne à titre d'exemple les dimensions et les compositions respectives des quatre couches épitaxiales d'une diode réalisée selon l'invention.

| n° de couche | épaisseur | composition x | dopant | porteurs libres en at/cm$^3$ |
|---|---|---|---|---|
| 1 | 1 $\mu$m | 0,3 | Ge | $10^{17}$ |
| 2 | 1 à 4 $\mu$m | 0,05 | Ge | $10^{16}$ à $10^{17}$ |
| 3 | 1 $\mu$m | 0,3 | Sn | $10^{17}$ |
| 4 | 4 $\mu$m | 0,1 | Te | $10^{18}$ |

Dans ce tableau: x définit la proportion d'aluminium dans la composition de chaque couche, la formule générale étant: $Ga_{1-x}$, $Al_x$, As. La longueur d'onde de la lumière étant de l'ordre de 0,9 $\mu$m. La diode selon l'invention a pour avantage la valeur élevée de son rendement global maximal. Ce rendement peut être défini par le rapport du courant détecté par une diode fonctionnant en détectrice au courant injecté dans une diode indentique fonctionnant en émission, et couplée optiquement à la première avec un coefficient de couplage égal à 1. Ce rendement dans la diode selon l'invention est de l'ordre de $10^{-3}$. Une autre caractérisque est le temps de montée global, défini de façon analogue, qui peut atteindre 20 ns. D'autres matériaux semiconducteurs peuvent être utilisés, tel se système quaternaire Ga InP As, déposé sur un substrat en Phosphure d'Indium. La couche 40 peut être une simple couche diélectrique. De plus, si le substrat est transparent, la diode peut servir de composant principal dans une ligne de télécommunication optique de type "bus".

Dans les figures 5 et 6 des références numériques identiques à celles apparaissant dans les figures 1 à 4 désignent des éléments similaires ou remplissant la même fonction.

La figure 5 représente en coupe un autre exemple de réalisation dans lequel le substrat est transparent. Pour une longueur d'onde de 1, 1 $\mu$m, le Phosphure d'Indium InP répond à cette condition.

La diode est soudée à l'envers sur un contact métallique 6. Celui-ci étant proche des jonctions, assure facilement la dissipation de la chaleur de fonctionnement. La rayonnement pénètre dans le substrat, ou en sort suivant le cas. Un contact 43 est pris sur le substrat.

La figure 6 représente un troisième exemple de réalisation. Dans cet exemple la zone 4 a un dopage de type n et forme une jonction redresseuse avec la zone 3 de type p.

Dans la partie centrale de cette zone, a été formée une diffusion 42, dont la profondeur est supérieure à celle de la zone 4, et qui par conséquent s'étend dans la zone 3. Cette diffusion est du type p.

Dans un exemple particulier, sur un substrat en Ga As de type n dopé au silicium (densité $10^{18}$ at/cm$^3$), on a déposé les quatre couches 1, 2, 3 et 4, dont les paramétres sont résumés dans le tableau suivant.

| n° de couche | épaisseur | x | type | dopant | concentration porteurs libres At/cm$^3$ |
|---|---|---|---|---|---|
| 1 | 1 $\mu$m | 0,3 | n | Sn | $10^{17}$ |
| 2 | 1 à 4 $\mu$m | 0,05 | p | Ge | $10^{16}$—$10^{18}$ |
| 3 | 1 $\mu$m | 0,3 | p | Ge | $10^{17}$ |
| 4 | 4 $\mu$m | 0,1 | n | Sn | $10^{16}$ |

dans lequel x représente la paramètre $Ga_{1-x} Al_x As$. Puis, par un procédé de masquage laissant à nu la région centrale 4 et un traitement thermique, la diffusion de zinc est pratiquée, et la profondeur de diffusion est comprise entre l'épaisseur de la zone 4, et la somme des épaisseurs des zones 3 et 4. Il en résulte que dans la zone centrale, la couche 3 est en contact avec une zone de même type de conductivité et que dans la zone périphérique elle est en contact avec une couche de type de conductivité opposée.

En polarisation directe, le courant électrique est bloquée dans la zone 4, la jonction 4—3 étant polarisée en inverse. L'émission de lumière se fait uniquement dans la région 42. En polarisation inverse, la diode se comporte comme dans les exemples précédents.

## Revendications

1. Diode photoémissive et photodétectrice pour une radiation prédéterminée, du type comportant:

un substrat (10) semiconducteur d'un premier type de conductivité;

une première couche (1) semiconductrice du même type de conductivité mais moins fortement dopée que le substrat (10);

une deuxième couche (2) semiconductrice constituant la couche active, dont le matériau présente une bande interdite moins large que celle de la première couche, dopée p;

une troisième couche (3) semiconductrice d'un second type de conductivité opposé audit premier type, dont le matériau présente une bande interdite plus large que celle de la deuxième couche,

caractérisée en ce qu'elle comporte en outre une quatrième couche semiconductrice présentant une région centrale (4) du même type de conductivité que la troisième couche et une région périphérique (40) de grande résistance ohmique, délimitée par une gravure mésa.

2. Diode photoémissive et photodétectrice pour une radiation prédéterminée, du type comportant:

un substrat (10) semiconducteur d'un premier type de conductivité;

une première couche (1) semiconductrice du même type de conductivité mais moins fortement dopée que le substrat (10);

une deuxième couche (2) semiconductrice constituant la couche active, dont le matériau présente une bande interdite moins large que celle de la première couche, dopée p;

une troisième couche (3) semiconductrice d'un second type de conductivité opposé audit premier type, dont le matériau présente une bande interdite plus large que celle de la deuxième couche, caractérisée en ce qu'elle comporte en outre une quatrième couche semiconductrice constituée par un matériau d'un type de conductivité opposé à celui de la troisième couche dans lequel on a effectué une diffusion d'impuretés du même type de conductivité que la troisième couche dans la région centrale (42), la région périphérique (4) demeurant du même type de conductivité et étant délimitée par une gravure mésa.

3. Diode selon la revendication 1, caractérisée en ce que la région périphérique (40) de la quatrième couche a été rendue isolante par implantation protonique préalable.

4. Diode selon l'une des revendications 1 et 2, caractérisée en ce que le matériau semiconducteur des première, deuxième, troisième et quatrième couche est de formule:

$$Ga_{1-x} Al_x As$$

dans laquelle x est différent, dans la deuxième couche, des valeurs qu'il prend dans les autres couches.

5. Diode selon la revendication 1, caractérisée en ce que l'on y trouve:
un substrat (10) en GaAs dopé $p^+$;
une première couche (1) dopée p en $Ga_{0,7} Al_{0,3} As$;
une deuxième couche (2) dopée p en $Ga_{0,95} Al_{0,05} As$;
une troisième couche (3) dopée n en $Ga_{0,7} Al_{0,3} As$;
une quatrième couche (4) dopée n en $Ga_{0,9} Al_{0,1} As$.

6. Diode selon la revendication 2, caractérisée en ce que l'on y trouve:
un substrat (10) en GaAs dopé $n^+$;
une première couche (1) dopée n en $Ga_{0,7} Al_{0,3} As$;
une deuxième couche (2) dopée p en $Ga_{0,95} Al_{0,05} As$;
une troisième couche (3) dopée p en $Ga_{0,7} Al_{0,3} As$;
une quatrième couche en $Ga_{0,9} Al_{0,1} As$ dopée p dans la région centrale (42), la région périphérique (4) étant dopée n.

7. Diode selon la revendication 1, caractérisée en ce que la quatrième couche (4) est soudée à un contact métallique (6), le rayonnement émis ou reçu traversant le substrat (10).

**Claims**

1. A light-emitting and light-detecting diode for a predetermined radiation, of the type comprising:
a semiconductor substratum (10) having a first type of conductivity;
a first semiconductor layer (1) having the same type of conductivity, but being less strongly doped than said substratum;
a second semiconductor layer (2) constituting the active layer, the material of which has a prohibited band less large than that of the first layer, doped p;
a third semiconductor layer (3) having a second type of conductivity opposed to the first type, the material of which has a prohibited band larger than that of the second layer;
characterized in that it further comprises a fourth semiconductor layer having a central area (4), the type of conductivity of which is the same as that of the third layer, and a peripheral area (40) having a high ohmic resistivity, and being delimited by a mesa engraving.

2. A light-emitting and light-detecting diode for a predetermined radiation, of the type comprising:
a semiconductor substratum (10) having a first type of conductivity;
a first semiconductor layer (2) having the same type of conductivity, but being less strongly doped than the substratum (10);
a second semiconductor layer (2) constituting the active layer, the material of which has a prohibited band less large than that of the first layer, of the p-doped type;
a third semiconductor layer of a second type of conductivity opposed to the first type, the material of which has a prohibited band larger than that of said second layer, characterized in that it further comprises a fourth semiconductor layer constituted by a material having a type of conductivity opposed to that of the third layer wherein impurities have been diffused which have the same type of conductivity as that of the third layer in the central area (42), the peripheral area (4) remaining of the same type of conductivity and being delimited by a mesa engraving.

3. A diode according to claim 1, characterized in that the peripheral area (40) of the fourth layer has been rendered insulating by previous protonic implantation.

4. A diode according to any one of claims 1 and 2, characterized in that the semiconductor material of said first, second, third and fourth layers corresponds to the formula:

$$Ga_{1-x} Al_x As$$

wherein x is different in the second layer from the values it assumes in the remaining layers.

5. A diode according to claim 1, characterized in that it comprises:
a $p^+$ doped GaAs substratum (10);
a p doped first $Ga_{0.7} Al_{0.3} As$ layer (1);
a p doped second $Ga_{0.95} Al_{0.05} As$ layer (2);
a n doped third $Ga_{0.7} Al_{0.3} As$ layer (3);
a n doped fourth $Ga_{0.9} Al_{0.1} As$ layer.

6. A diode according to claim 2, characterized in that it comprises:
a $n^+$ doped GaAs substratum (10);

a n doped first $Ga_{0.7}$ $Al_{0.3}$ As layer (1);
a p doped second $Ga_{0.95}$ $Al_{0.05}$ As layer (2);
a p doped third $Ga_{0.7}$ $Al_{0.3}$ As layer (3);
a fourth $Ga_{0.9}$ $Al_{0.1}$ As layer with p doping in the central area (42), the peripheral area (4) being n doped.

7. A central diode according to claim 1, characterized in that the fourth layer (4) is welded to a metallic contact (6), and in that the emitted or received radiation passes through the substrate (10).

**Patentansprüche**

1. Lichtemissions= und Lichtdetektordiode für eine vorbestimmte Strahlung, umfassend:
eine Halbleitergrundschicht (10) mit einem ersten Leitfähigkeitstyp;
eine erste Halbleiterschicht (1) mit dem gleichen Leitfähigkeitstyp, aber schwächer dotiert als die Grundschicht (10);
eine zweite, die aktive Schicht bildende Halbleiterschicht (2), deren Material einen Sperrbereich besitzt, welcher schmaler ist, als derjenige der ersten Schicht, p-dotiert;
eine dritte Halbleiterschicht (3) mit einem dem ersten Leitfähigkeitstyp entgegengesetzten Leitfähigkeitstyp, wobei das Material dieser dritten Schicht einen Sperrbereich besitzt, welcher breiter ist, als derjenige der zweiten Schicht;
dadurch gekennzeichnet, dass sie ferner eine vierte Halbleiterschicht aufweist, die eine zentrale Zone (4) mit dem gleichen Leitfähigkeitstyp wie derjenige der dritten Schicht besitzt, sowie eine peripherische Zone (4), die einen hohen ohmischen Widerstand hat und durch eine Mesa-Gravierung begrenzt ist.

2. Lichtemissions= und Lichtdetektordiode für eine vorbestimmte Strahlung, umfassend:
eine Halbleitergrundschicht (1) mit einem ersten Leitfähigkeitstyp;
eine erste Halbleiterschicht (1) mit dem gleichen Leitfähigkeitstyp, jedoch schwächer dotiert als die Grundschicht (10);
eine zweite Halbleiterschicht (2), die die aktive Schicht bildet und deren Material einen Sperrbereich besitzt, der schmaler ist, als derjenige der ersten Schicht, p-dotiert;
eine dritte Halbleiterschicht (3) mit einem zweiten Leitfähigkeitstyp, der dem ersten Leitfähigkeitstyp entgegengesetzt ist, und dessen Material eine Sperrschicht definiert, die breiter ist, als diejenige der zweiten Schicht, dadurch gekennzeichnet, dass sie ferner eine vierte Halbleiterschicht aufweist, deren Material einen Leitfähigkeitstyp aufweist, welcher demjenigen der dritten Schicht entgegengesetzt ist und in welchem Verunreinigungen mit dem gleichen Leitfähigkeitstyp wie derjenige der dritten Schicht in der mittleren Zone (42) diffundiert sind, wobei die peripherische Zone (4) den gleichen Leitfähigkeitstyp beibehält und durch eine Mesa-Gravierung begrenzt ist.

3. Diode nach Anspruch 1, dadurch gekennzeichnet, dass die peripherische Zone (40) der vierten Schicht durch vorhergehende protonische Einpflanzung isolierend gemacht worden ist.

4. Diode nach Anspruch 1 oder 2, dadurch gekennzeichnet, dass das Halbleitermaterial der ersten, zweiten, dritten und vierten Schicht der Formel

$$Ga_{1-x} Al_x As$$

entspricht, wobei x in der zweiten Schicht einen Wert darstellt, der von demjenigen in den anderen Schichten verschieden ist.

5. Diode nach Anspruch 1, dadurch gekennzeichnet, dass sie umfasst:
eine $p^+$ dotierte Ga As Grundschicht (10);
eine erste p-dotierte $Ga_{0.7}$ $Al_{0.3}$ As Schicht (1);
eine zweite p-dotierte $Ga_{0.95}$ $Al_{0.05}$ As Schicht (2);
eine dritte n-dotierte $Ga_{0.7}$ $Al_{0.3}$ As Schicht (3);
eine vierte, n-dotierte $Ga_{0.9}$ $Al_{0.1}$ As Schicht (4).

6. Diode nach Anspruch 2, dadurch gekennzeichnet, dass sie umfasst:
eine $n^+$-dotierte Grundschicht (10);
eine erste n-dotierte $Ga_{0.7}$ $Al_{0.3}$ As Schicht (1);
eine zweite p-dotierte $Ga_{0.95}$ $Al_{0.05}$ As Schicht (2);
eine dritte p-dotierte $Ga_{0.7}$ $Al_{0.3}$ As Schicht (3);
eine vierte p-dotierte $Ga_{0.9}$ $Al_{0.1}$ As Schicht in der mittleren Zone (42), wobei die peripherische Zone (4) n-dotiert ist.

7. Diode nach Anspruch 1, dadurch gekennzeichnet, dass die vierte Schicht (4) an einen metallischen Kontakt (6) angeschweisst ist, wobei die emittierte bzw. empfangene Strahlung die Grundschicht (10) durchquert.

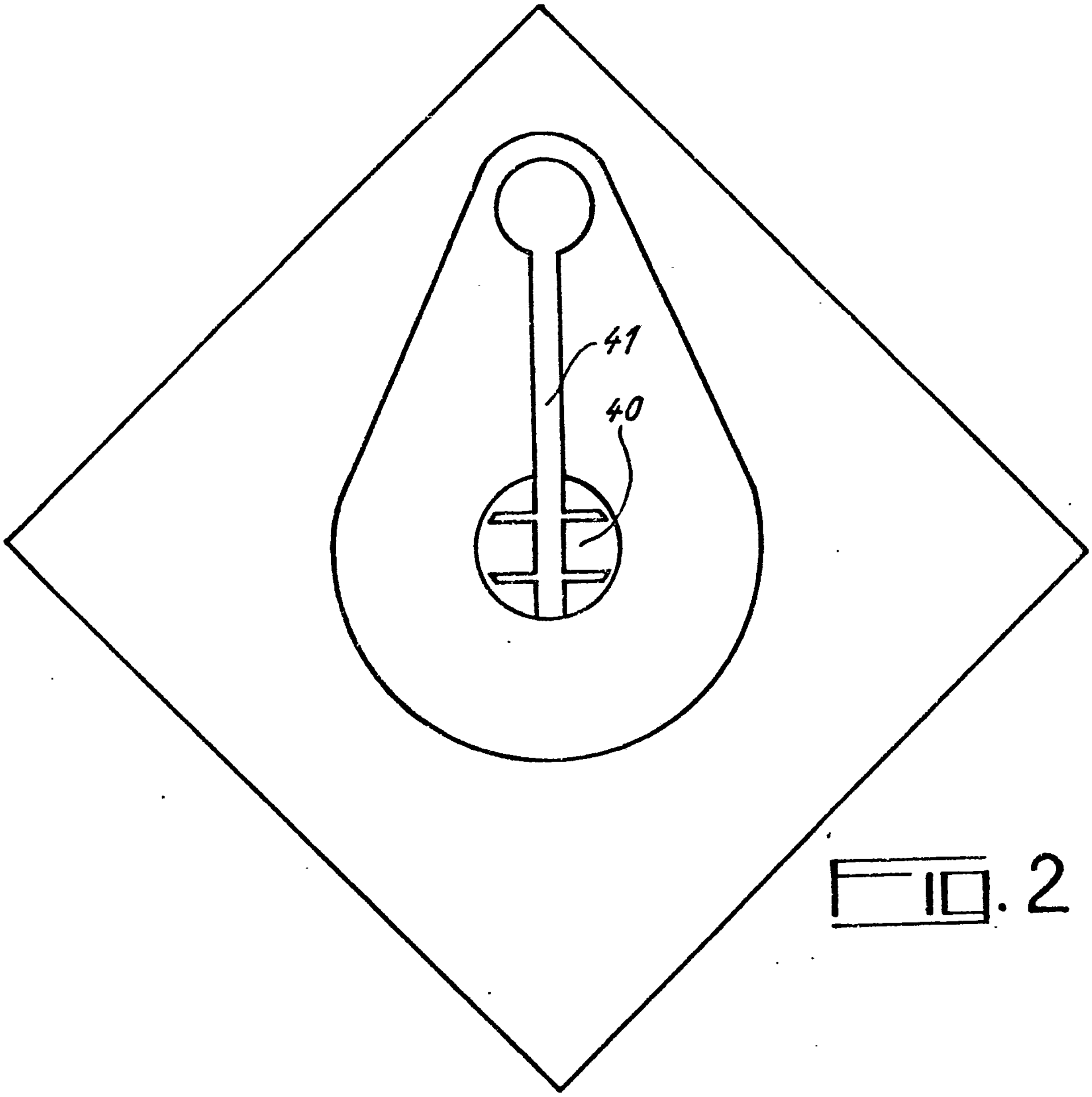


FIG. 2

FIG. 1

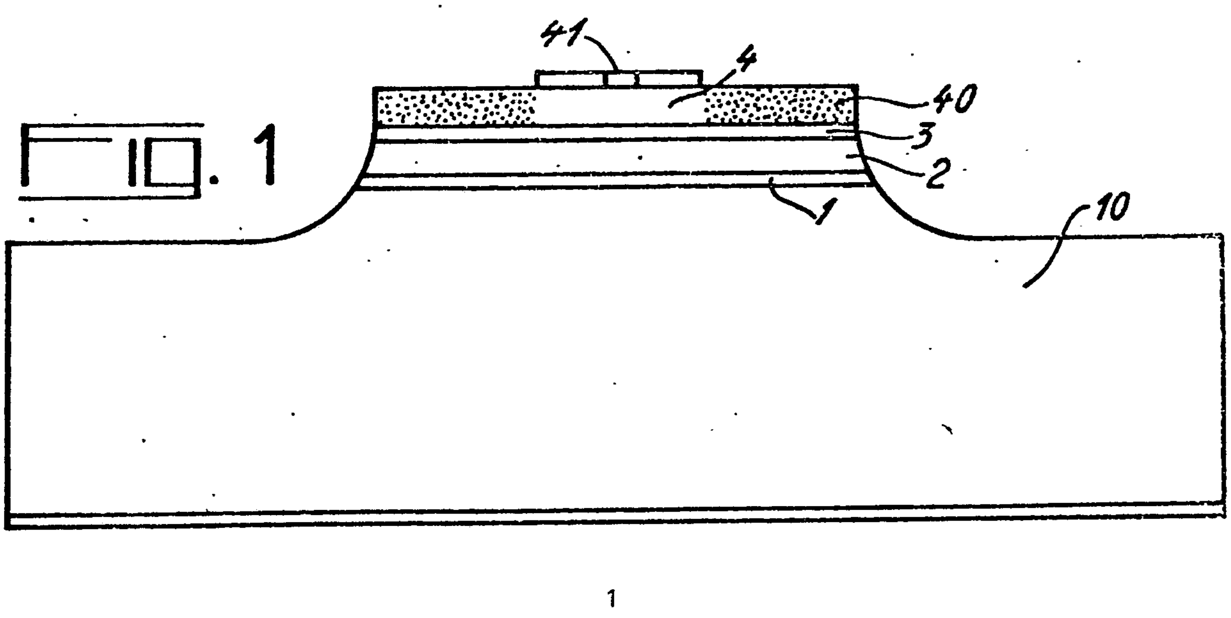

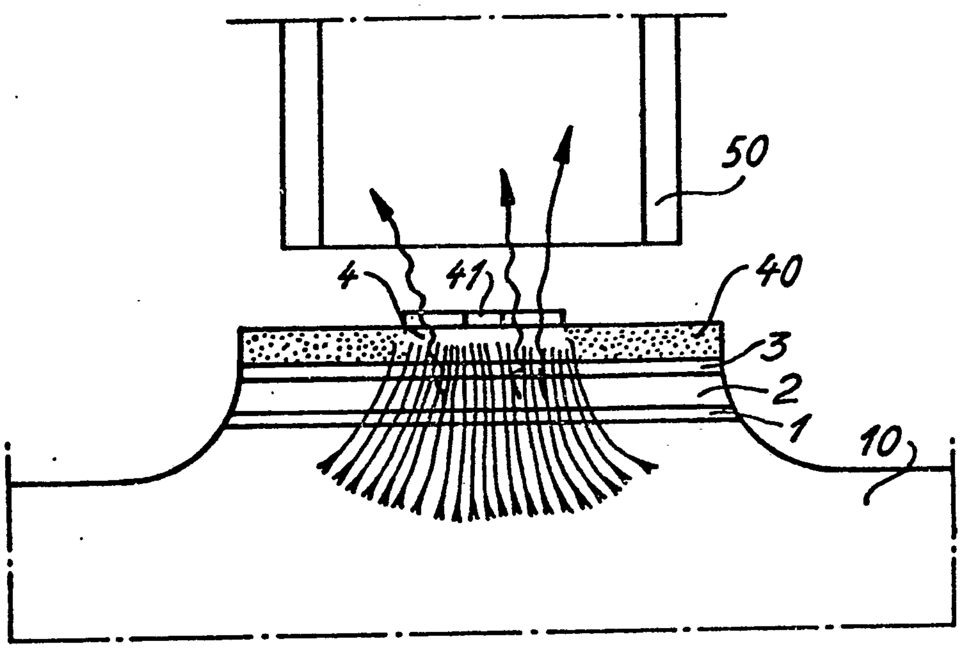


FIG. 3

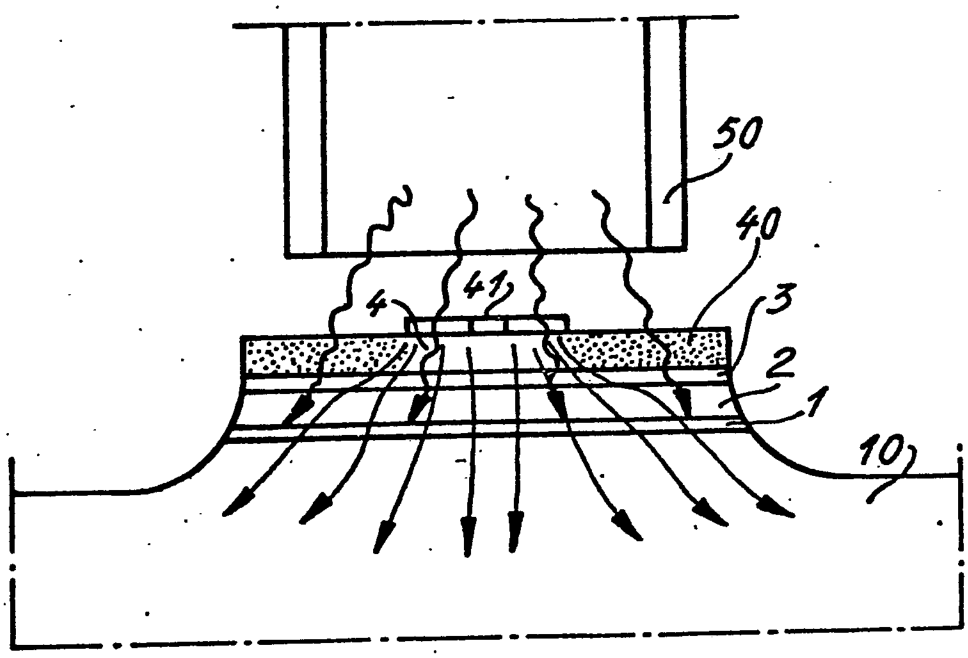


FIG. 4

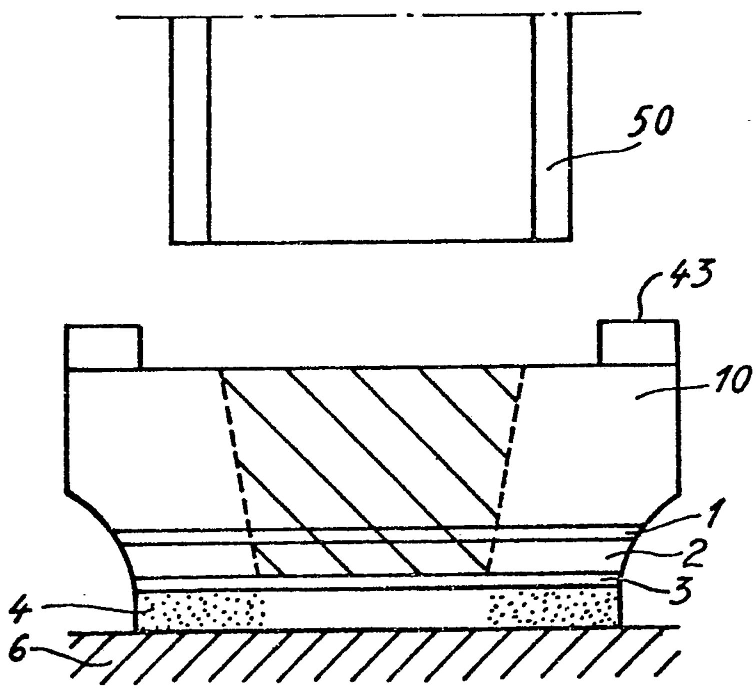


FIG. 5

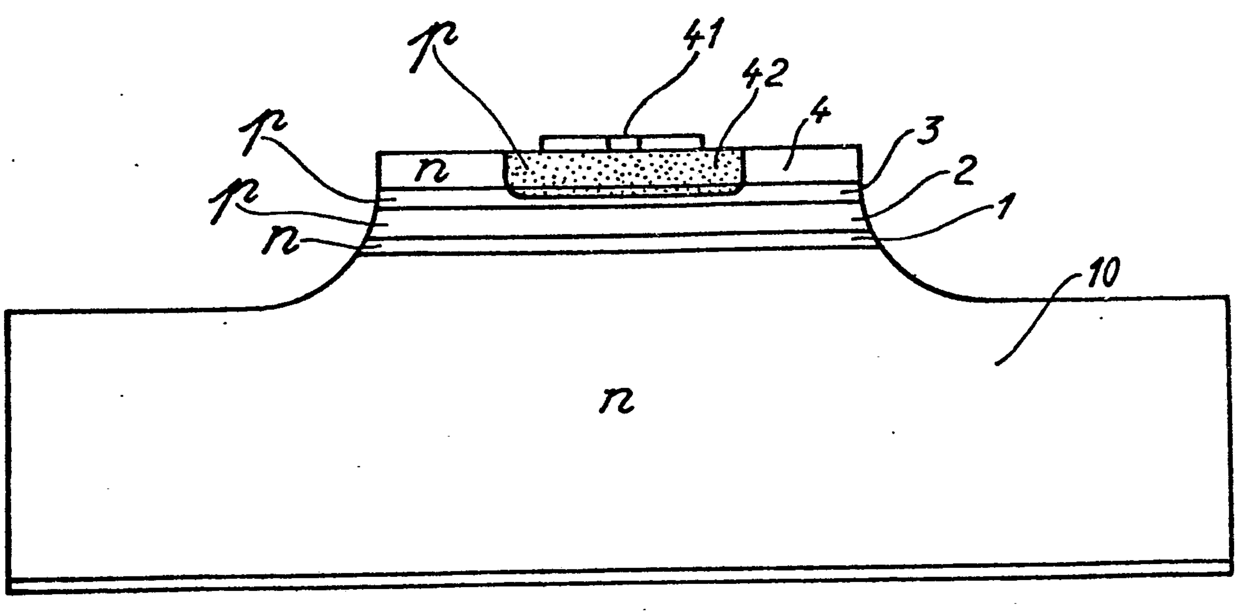


FIG. 6